(19) Europäisches Patentamt
European Patent Office
Office européen des brevets

(11) **EP 3 683 558 A1**

(12) **EUROPÄISCHE PATENTANMELDUNG**

(43) Veröffentlichungstag:
**22.07.2020 Patentblatt 2020/30**

(51) Int Cl.:
*G01J 3/51* (2006.01)   *H01L 31/0216* (2014.01)
*H01L 27/146* (2006.01)   *H04N 9/04* (2006.01)

(21) Anmeldenummer: **19152093.1**

(22) Anmeldetag: **16.01.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **SICK AG**
**79183 Waldkirch (DE)**

(72) Erfinder:
• **MÜLLER, Romain**
**79252 Stegen (DE)**
• **SCHNEIDER, Florian**
**79276 Reute (DE)**

(74) Vertreter: **Manitz Finsterwald**
**Patent- und Rechtsanwaltspartnerschaft mbB**
**Martin-Greif-Strasse 1**
**80336 München (DE)**

(54) **FARBBILDSENSOR**

(57)   Die vorliegende Erfindung betrifft einen Farbbildsensor mit einer Anordnung von Sensorelementen einer ersten Art, die auf Strahlung in einem ersten Spektralbereich empfindlich sind, Sensorelementen einer zweiten Art, die auf Strahlung in einem zweiten Spektralbereich empfindlich sind, und Sensorelementen einer dritten Art, die auf Strahlung in einem dritten Spektralbereich empfindlich sind, wobei die drei Arten von Sensorelementen in sich wiederholendem Muster über die Fläche des Farbbildsensors verteilt sind. Erfindungsgemäß ist vorgesehen, dass der erste Spektralbereich nur eine erste und eine zweite Grundfarbe, der zweite Spektralbereich nur die zweite und eine dritte Grundfarbe und der dritte Spektralbereich zumindest die erste und die dritte Grundfarbe umfasst.

Fig. 2

**Beschreibung**

Die vorliegende Erfindung betrifft einen Farbbildsensor mit einer Anordnung von Sensorelementen einer ersten Art, die auf Strahlung in einem ersten Spektralbereich empfindlich sind, Sensorelementen einer zweiten Art, die auf Strahlung in einem zweiten Spektralbereich empfindlich sind, und Sensorelementen einer dritten Art, die auf Strahlung in einem dritten Spektralbereich empfindlich sind, wobei die drei Arten von Sensorelementen in sich wiederholendem Muster über die Fläche des Farbbildsensors verteilt sind.

Derartige Farbbildsensoren werden zum Beispiel in digitalen Kameras, insbesondere Foto- und Filmkameras, eingesetzt. Herkömmliche Farbbildsensoren sind in der Regel nach Art eines Bayer-Sensors ausgestaltet, bei dem eine matrixförmige Anordnung von lichtempfindlichen Sensorelementen mit jeweiligen Filtern unterschiedlicher spektraler Durchlässigkeit bedeckt sind, wobei zum Beispiel 50 % aller Pixel oder Sensorelemente mit einem Grünfilter und je 25 % der Pixel mit einem Rot- bzw. einem Blaufilter bedeckt sind. Die verschiedenen Filter sind in Form eines regelmäßigen, sich wiederholenden Musters über den Farbbildsensor verteilt. Da Grün beim menschlichen Auge den größten Beitrag zur Helligkeitswahrnehmung und somit auch zur Kontrast- und Schärfewahrnehmung leistet, werden die für grünes Licht empfindlichen Pixel in doppelter Anzahl vorgesehen.

Ein derartiger Farbbildsensor weist jedoch nur eine eingeschränkte Lichtempfindlichkeit auf. Zur Erhöhung der Lichtempfindlichkeit werden verbesserte Sensoren eingesetzt, bei denen beispielsweise die Hälfte der grünen Pixel durch Pixel ersetzt werden, die für weißes Licht, d.h. für alle drei Grundfarben Rot (R), Grün (G) und Blau (B) empfindlich sind. Des Weiteren sind Ansätze bekannt, bei denen zwei verschiedene Grünfilter eingesetzt werden, welche für leicht unterschiedliche Spektralbereiche durchlässig sind. Weiterhin gibt es Ansätze, bei denen anstelle eines herkömmlichen Bayer-Musters mit einer 2x2-Elementarzelle der Pixelfarben ein abweichendes Verteilungsmuster der verschiedenen Pixelfarben verwendet wird.

Es ist die Aufgabe der vorliegenden Erfindung, einen Farbbildsensor anzugeben, welcher eine hohe Lichtempfindlichkeit aufweist.

Die Lösung der Aufgabe erfolgt durch einen Farbbildsensor mit den Merkmalen des Anspruchs 1. Erfindungsgemäß ist vorgesehen, dass der erste Spektralbereich nur eine erste und eine zweite Grundfarbe, der zweite Spektralbereich nur die zweite und eine dritte Grundfarbe und der dritte Spektralbereich zumindest die erste und die dritte Grundfarbe umfasst. Grundfarben sind diejenigen Farben, aus denen die gleiche Farbwahrnehmung, die Licht einer bestimmten spektralen Zusammensetzung bei einem Betrachter hervorruft, durch Mischen, insbesondere additives Mischen, dieser Grundfarben erzeugt werden kann. Für Farbbildsensoren werden in der Regel als Grundfarben die Farben Rot, Grün und Blau gewählt.

Bei Farbbildsensoren gemäß dem Stand der Technik sind alle oder zumindest der Großteil der Pixel oder Sensorelemente nur für eine Grundfarbe empfindlich. Die anderen beiden Grundfarben werden jeweils herausgefiltert, so dass die Intensität, die in den vom Filter blockierten Spektralbereichen vorhanden ist, nicht erfasst wird. Bei dem erfindungsgemäßen Farbbildsensor werden hingegen mindestens zwei Grundfarben bzw. die entsprechenden Spektralbereiche erfasst, so dass diese Pixel oder Sensorelemente im Vergleich zu Sensorelementen, die nur eine Grundfarbe detektieren können, eine deutlich erhöhte, theoretisch sogar doppelt so hohe Lichtempfindlichkeit aufweisen.

Beispielsweise kann bezogen auf die vorstehend genannten beispielhaften Grundfarben Rot, Grün und Blau der erste Spektralbereich die Grundfarben Rot und Grün umfassen, der zweite Spektralbereich die Grundfarben Grün und Blau und der dritte Spektralbereich die Grundfarben Rot und Blau oder alternativ alle drei Grundfarben Rot, Grün und Blau umfassen. Die Auswahl der Grundfarben und insbesondere deren Zuordnung zu den Spektralbereichen ist hier wie auch im weiter unten beschriebenen Ausführungsbeispiel rein beispielhaft.

Die erste Alternative für den dritten Spektralbereich entspricht somit einer vorteilhaften Ausführungsform, wonach der dritte Spektralbereich nur die erste und die dritte Grundfarbe umfasst.

Die zweite Alternative entspricht einer anderen vorteilhaften Ausführungsform, wonach der dritte Spektralbereich die erste, die zweite und die dritte Grundfarbe umfasst.

Bei allen Ausgestaltungen ist es möglich, die jeweiligen Grundfarben aus der Gesamtheit der von den Sensorelementen erzeugten Signale in geeigneter Weise zu extrahieren, was nachfolgend noch näher erläutert wird.

Gemäß einer vorteilhaften Ausführungsform sind die Sensorelemente durch lichtempfindliche Elemente gebildet, welche eine spektrale Empfindlichkeit für alle drei Grundfarben aufweisen, wobei die lichtempfindlichen Elemente der Sensorelemente der ersten Art mit einem jeweiligen Filter bedeckt sind, welches lediglich innerhalb des ersten Spektralbereichs durchlässig ist, und die lichtempfindlichen Elemente der Sensorelemente der zweiten Art mit einem jeweiligen Filter bedeckt sind, welches lediglich innerhalb des zweiten Spektralbereichs durchlässig ist. Die Bedeckung der Sensorelemente mit entsprechenden Filtern stellt in der Regel die einfachste und kostengünstigste Art zur Realisierung der gewünschten spektralen Empfindlichkeit dar. Als Filter für alle drei Spektralbereiche können beispielsweise dichroitische Filter oder Interferenzfilter eingesetzt werden, welche eine bestimmte Wellenlänge oder Grundfarbe, die in dem gewünschten Spektralbereich nicht vorhanden sein soll, reflektieren und für Spektralbereiche, welche die beiden gewünschten Grundfarben umfassen, durchlässig sind. Derartige dichroitische Filter sind allgemein bekannt. Weiterhin können auch Absorbtionsfilter verwendet werden.

Vorteilhafterweise sind die lichtempfindlichen Elemente der Sensorelemente der dritten Art mit einem jeweiligen Filter bedeckt, welches lediglich innerhalb des dritten Spektralbereichs durchlässig ist. Somit sind die Filter für die Sensorelemente der dritten Art je nach vorstehend genannter Ausführungsform in Abhängigkeit von der Definition des dritten Spektralbereichs für zwei oder drei Grundfarben durchlässig. Bei Filtern für Sensorelemente der dritten Art, welche für drei Grundfarben durchlässig sind, kann es sich beispielsweise um Filter handeln die unerwünschte nicht sichtbare Strahlung herausfiltern, beispielsweise ultraviolette und/oder infrarote Strahlung.

Alternativ können die lichtempfindlichen Elemente der Sensorelemente der dritten Art nicht mit einem Filter bedeckt sein. Mit anderen Worten kann für den Fall, dass der dritte Spektralbereich die drei Grundfarben umfasst, ein Filter auf den entsprechenden Sensorelementen auch entfallen.

Gemäß einer vorteilhaften Ausführungsform der Erfindung sind die Sensorelemente mit einer Auswerteeinrichtung verbunden, welche dazu eingerichtet ist, aus Signalen, die von benachbarten Sensorelementen der ersten, zweiten und dritten Art erzeugt wurden, für jede Grundfarbe eine jeweilige Signalkomponente zu ermitteln. Die Auswerteeinheit kann in den Farbbildsensor integriert sein oder als separate, mit dem Farbbildsensor verbundene Einheit ausgebildet sein. Die Auswerteeinrichtung errechnet aus den drei, den genannten Spektralbereichen zugeordneten Empfangskanälen des Farbbildsensors ein dreikanaliges Signal, bei dem jeder Kanal nur eine Grundfarbe umfasst, beispielsweise ein RGB-Signal. Unter benachbarten Sensorelementen werden insbesondere die unmittelbar nebeneinanderliegenden Sensorelemente bzw. die innerhalb einer definierten geometrischen Distanz liegenden Sensorelemente verstanden, beispielsweise diejenigen Sensorelemente, die für das eingangs genannte Muster eine Elementarzelle bilden.

Vorteilhafterweise ist die Auswerteeinrichtung dazu eingerichtet, die Signalkomponenten auf der Grundlage von algebraischen Operationen, bevorzugt durch Additions- und/oder Subtraktionsoperationen, besonders bevorzugt unter Berücksichtigung von jeweiligen Gewichtungs- oder Skalierungsfaktoren bzw. Gewichtungs- oder Skalierungsfunktionen zu ermitteln. Mit Hilfe der algebraischen Operationen lässt sich die Umrechnung des dreikanaligen Empfangssignals in ein standardisiertes Signal wie das genannte RGB-Signal mit vergleichsweise geringem Rechenaufwand bewerkstelligen. Die Gewichtungsfaktoren bzw. Gewichtungsfunktionen können insbesondere unterschiedliche spektrale Empfindlichkeiten, bevorzugt auch Nichtlinearitäten, kompensieren, so dass eine farbgetreue Bildaufnahme gegeben ist.

Grundsätzlich kann anstelle einer algebraischen Umrechnung auch eine Umrechnung mit Hilfe eines oder mehrerer neuronaler Netze erfolgen.

Gemäß einer vorteilhaften Ausführungsform ist die Anzahl der Sensorelemente der dritten Art größer als die Anzahl der Sensorelemente der ersten Art und die Anzahl der ersten Sensorelemente der zweiten Art, bevorzugt doppelt so groß. Hierdurch kann einer spektralen Empfindlichkeit des menschlichen Auges entsprechend eine unterschiedliche Gewichtung verschiedener Spektralbereiche erfolgen, so dass sich letztendlich die Gesamtempfindlichkeit des Farbsensors noch weiter erhöhen lässt. Bevorzugt sind die Anzahlen der Sensorelemente der ersten und der zweiten Art gleich groß.

Weitere vorteilhafte Ausführungsformen der Erfindung ergeben sich aus den Unteransprüchen, der Beschreibung und den Zeichnungen.

Die Erfindung wird nachfolgend anhand eines Ausführungsbeispiels mit Bezug auf die Zeichnungen beschrieben. Es zeigt:

Fig. 1   spektrale Empfindlichkeiten für Sensorelemente eines Farbbildsensors gemäß dem Stand der Technik, und

Fig. 2   spektrale Empfindlichkeiten für Sensorelemente eines Farbbildsensors gemäß einem Ausführungsbeispiel der Erfindung, und

Fig. 3   ein Diagramm, welches mittels einer Simulation Farbabweichungen in Gestalt der euklidischen Distanz zwischen vorgegebenen RGB-Tupeln und errechneten RGB-Tupeln visualisiert.

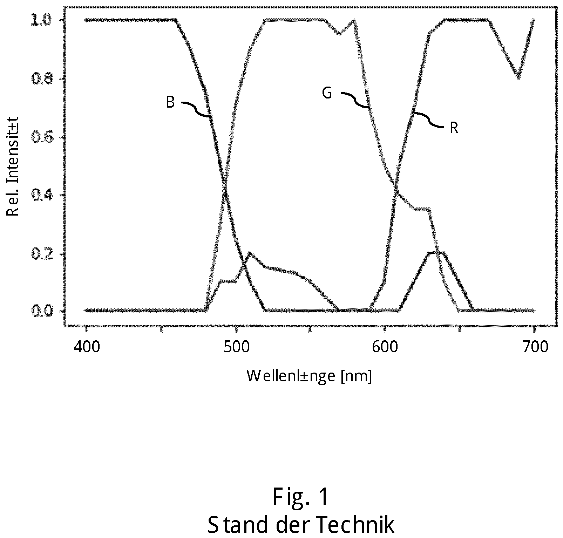

Fig. 1 zeigt die spektrale Empfindlichkeit für einen herkömmlichen Farbbildsensor mit drei verschiedenen Arten von Sensorelementen, wobei eine erste Art von Sensorelementen nur für die Grundfarbe Rot, eine zweite Art von Sensorelementen nur für die Grundfarbe Grün und eine dritte Art von Sensorelementen nur für die Grundfarbe Blau empfindlich ist. Die Empfindlichkeiten sind auf eine relative Intensität in einem Wertebereich zwischen 0 und 1 normiert.

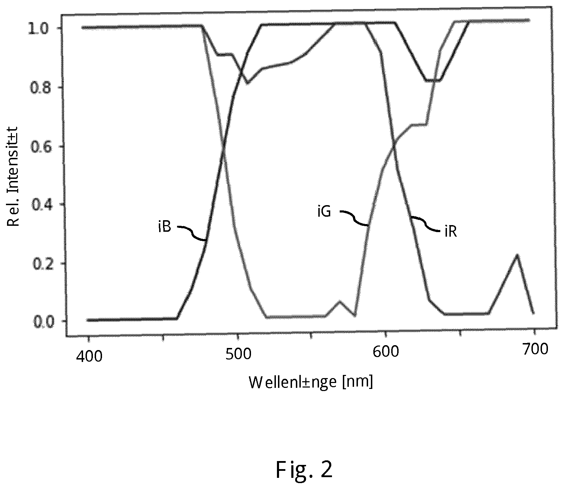

Fig. 2 zeigt ein entsprechendes Diagramm für die spektralen Empfindlichkeiten für einen Farbbildsensor gemäß einem Ausführungsbeispiel der Erfindung. Demnach umfasst der Farbbildsensor Sensorelemente einer ersten Art, die auf Strahlung in einem ersten Spektralbereich S1 empfindlich sind, welcher die Grundfarben Rot (R) und Grün (G) umfasst. Der erste Spektralbereich S1 lässt sich auch als invertiert Blau (iB) bezeichnen. Die Sensorelemente der zweiten Art sind auf Strahlung in einem zweiten Spektralbereich S2 empfindlich, welcher die Grundfarben Grün und Blau (B) umfasst und auch als invertiert Rot (iR) bezeichnet werden kann. Schließlich sind Sensorelemente einer dritten Art, auf Strahlung in einem dritten Spektralbereich S3 empfindlich, welcher die Grundfarben Rot und Blau umfasst und auch als invertiert Grün (iG) bezeichnet werden kann.

Zusammengefasst gilt also für das Ausführungsbeispiel:

$$S1 = R + G = iB$$

$$S2 = G + B = iR$$

$$S3 = R + B = iG,$$

wobei jedes der in den Gleichungen verwendeten Symbole oder Kurzzeichen eine entsprechende Intensität verkörpern kann.

Eine Extraktion der Werte für Rot, Grün und Blau (RGB-Werte), die hier als R*, G* und B* bezeichnet werden, aus den Spektralbereichen S1 bis S3 kann gemäß den folgenden Gleichungen erfolgen:

$$R^* = S1 + S3 - S2 = (R + G) + (R + B) - (G + B) = 2\,R$$

$$G^* = S1 + S2 - S3 = (R + G) + (G + B) - (R + B) = 2\,G$$

$$B^* = S2 + S3 - S1 = (R + B) + (G + B) - (R + G) = 2\,B$$

Die drei Arten von Sensorelementen können in gleicher Anzahl vorhanden sein. Grundsätzlich kann ähnlich wie einem Bayer-Sensor eine einzelne Art in doppelter Anzahl vertreten sein, was bei der Umrechnung durch Mittelung von jeweils zwei benachbarten Sensorelementen dieser Art oder entsprechende Gewichtung berücksichtigt werden kann.

Nachfolgend wird anhand eines schematischen Vergleichs der Signalintensitäten für einen herkömmlichen Farbsensor, bei dem jeder der drei Spektralbereiche nur eine Grundfarbe umfasst, mit einem erfindungsgemäßen Farbbildsensor gemäß dem vorliegenden Ausführungsbeispiel eine Erhöhung einer gemessenen Signalintensität bzw. eine Verbesserung der Empfindlichkeit illustriert.

Es sei angenommen, dass beide Farbbildsensoren jeweils mit weißem Licht gleicher Intensität beleuchtet werden, wobei die Intensität so gewählt ist, dass ein Sensorelement ohne ein Filter einen (arbiträren) Intensitätswert von 255 ergibt. Des Weiteren wird angenommen, dass die Intensität auf die drei Spektralbereiche dieser Farbbildsensoren gleich verteilt ist, und dass die Konversionsrate des Sensors, welche z.B. als Intensitätswert (oder Einheit) pro erfasster Energieeinheit beschrieben werden kann, für beide Sensoren gleich ist.

Für den herkömmlichen Farbbildsensor gemäß dem Stand der Technik, bei dem die drei Arten von Sensorelementen jeweils Filter aufweisen, welche nur eine Grundfarbe hindurch lassen, ergibt sich jeweils ein Wert von 85 für jeden Spektralbereich, d.h. S1 = S2 = S3 = R = G = B = 85. Jedes Filter absorbiert (oder reflektiert) jeweils 170 Einheiten, die dann vom Sensor nicht mehr erfasst werden können.

Für den erfindungsgemäßen Farbbildsensor, bei dem gemäß dem Ausführungsbeispiel jeder Spektralbereich zwei Grundfarben umfasst, ergibt sich aus den oben Gleichungen für jeden Spektralbereich S1 bis S3 eine doppelt so hohe Intensität, da jede Grundfarbe in zwei der drei Spektralbereichen vorkommt und daher auch von jeweils zwei Sensorelementen unterschiedlicher Art erfasst werden. Dies bedeutet, dass gemäß oben stehender Gleichungen jeder Spektralbereich S1 bis S3 und daraus abgeleitet auch jede Grundfarbe R*, G*, B* des aus den Spektralbereichen S1 bis S3 errechneten RGB-Spektrums einen Intensitätswert von 170 aufweisen, d.h. es gilt:

$$S1 = S2 = S3 = R^* = G^* = B^* = 170.$$

Dieser Vergleich zeigt, dass ein erfindungsgemäßer Farbsensor gegenüber einem Farbsensor gemäß dem eingangs geschilderten Stand der Technik zumindest theoretisch eine doppelt so hohe Empfindlichkeit aufweist. Abweichungen von dieser Verdoppelung können sich in der Praxis z.B. aus einer reduzierten Transmissivität der verwendeten Filter oder anderer Effekte ergeben.

Für einen erfindungsgemäßen Farbsensor gemäß dem oben genannten Ausführungsbeispiel wurde des Weiteren eine Simulation durchgeführt, um die Farbtreue eines neuronalen Netzes zu ermitteln, das in alternativer Weise für die Umrechnung der von den Sensorelementen für die drei jeweiligen Spektralbereiche S1 bis S3 ermittelten Intensitätswerte in RGB-Werte herangezogen wurde.

Hierfür wurden mittels einer Simulation verschiedener zufällig gebildeter RGB-Tupel Intensitätswerte für den ersten bis dritten Spektralbereich S1 bis S3 des beispielhaften erfindungsgemäßen Farbbildsensors unter Berücksichtigung der spektralen Durchlässigkeit der jeweiligen Filter für die Sensorelemente errechnet. Diese simulierten Intensitätswerte für die Spektralbereiche S1 bis S3 wurden einem neuronalen Netz zugeführt, welches daraus wieder entsprechende RGB-Intensitätswerte ermittelt.

Die Farbabweichung eines von dem neuronalen Netz ermittelten RGB-Tupels von dem vorgegebenen RGB-Tupel lässt sich mit Hilfe der euklidischen Distanz D ausdrücken:

$$D = \sqrt{(R_M - R_T)^2 + (G_M - G_T)^2 + (B_M - B_T)^2},$$

wobei $R_M$, $G_M$, $B_M$ die mittels des neuronalen Netzes aus den Spektralbereichen S1 bis S3 errechneten RGB-Werte sind, während $R_T$, $G_T$, $B_T$ die RGB-Werte des vorgegebenen RGB-Tupels bezeichnen.

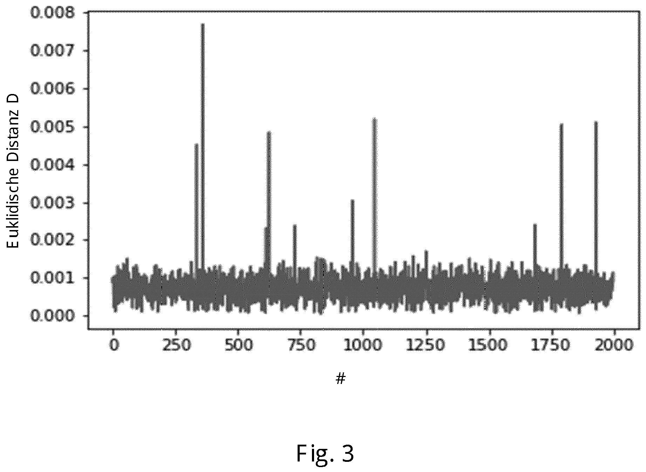

Eine beispielhafte Simulation wurde für 2000 verschiedene RGB-Tupel durchgeführt, deren arbiträre Nummerierung in Fig. 3 auf der horizontalen Achse angegeben ist. Für diese 2000 RGB-Tupel ist jeweils die euklidische Distanz D dargestellt, wobei die jeweiligen Werte für R, G und B innerhalb eines normierten Bereichs zwischen 0 und 1 liegen. Wie in diesem Diagramm von Fig. 3 gut zu erkennen ist, beträgt die euklidische Distanz für mehr als 99 % aller Tupel ungefähr 0,001.

Ein Vergleich der vorgegebenen und der ermittelten RGB-Tupel durch Wiedergabe auf einem Computerbildschirm bzw. in einem Ausdruck hat ergeben, dass die Farbabweichungen mit dem menschlichen Auge kaum zu erkennen sind.

Gemäß einer Abwandlung des beispielhaften Farbbildsensors kann der dritte Spektralbereich S3 auch alle drei Grundfarben Rot, Grün und Blau umfassen und kann daher auch als Weiß (W) bezeichnet werden.

Der dritte Spektralbereich lässt sich dann durch

$$S3 = W = R + G + B \text{ definieren.}$$

Es gilt dann mit

$$S1 = R + G = iB$$

$$S2 = G + B = iR$$

wie beim ursprünglichen Ausführungsbeispiel für die umgerechneten RGB-Werte R*, G*, B*:

$$R* = S3 - S2 = W - iR = (R + G + B) - (G + B) = R$$

$$G* = S1 + S2 - S3 = (iB + iR - W) = (R + G) + (G + B) - (R + G + B) = 2G$$

$$B* = S3 - S1 = W - iB = (R + G + B) - (R + G) = B$$

Bei der Abwandlung ergibt sich eine doppelte bzw. zumindest erhöhte Empfindlichkeit nur für den grünen Spektralbereich, was jedoch dem Sehempfinden des menschlichen Auges entspricht, bei dem Grün den größten Beitrag zur Helligkeitswahrnehmung und somit auch zur Kontrast- und Schärfe-Wahrnehmung leistet.

Um hier eine andere spektrale Empfindlichkeitsverteilung zu erreichen, kann z.B. ein Muster mit einer Elementarzelle verwendet werden, bei welcher der Spektralbereich S3 mit zwei Sensorelementen und die Spektralbereiche S1 und S2 mit je einem Sensorelement vertreten sind. Dementsprechend ist die Anzahl der Sensorelemente der dritten Art doppelt so groß wie die Anzahl der Sensorelemente der ersten oder der zweiten Art.

Bei einer 2x2-Matrix als Elementarzelle können die Sensorelemente, welche im Spektralbereich S3 empfindlich sind, beispielsweise auf eine der Diagonalen angeordnet sein. Hierbei ist jedes Sensorelement der ersten bzw. der zweiten Art, welche für den ersten Spektralbereich S1 oder den zweiten Spektralbereich S2 empfindlich sind, von vier Sensorelementen der dritten Art umgeben, welche für den dritten Spektralbereich empfindlich sind. Als Wert für S3 bzw. W kann zum Beispiel ein Mittelwert der Intensität von vier benachbarten Sensorelementen der dritten Art herangezogen werden.

Alternativ kann auch festgelegt werden, dass immer ein jeweiliger bestimmter Nachbar zur Ermittlung des S3-Werts herangezogen wird, beispielsweise das S3-Sensorelement links von einem jeweiligen S1- oder S2-Sensorelement.

Die Auswertung der Spektralbereiche bzw. deren Umrechnung ist hier vereinfacht durch rein lineare arithmetische Operationen beschrieben worden. Grundsätzlich können in die Umrechnungsgleichungen auch Skalierungen verschiedener Ordnungen, z.B. Offsets, lineare und nichtlineare Skalierungsfaktoren, mit einbezogen werden.

Vorteilhafterweise können hier auch neuronale Netze zum Einsatz gelangen.

**Bezugszeichenliste**

R    Rot
G    Grün
B    Blau
W    Weiß

iR    invertiert Rot
iG    invertiert Grün
iB    invertiert Blau

S1    erster Spektralbereich
S2    zweiter Spektralbereich
S3    dritter Spektralbereich


**Patentansprüche**

1.  Farbbildsensor, mit einer Anordnung von Sensorelementen einer ersten Art, die auf Strahlung in einem ersten Spektralbereich (S1) empfindlich sind, Sensorelementen einer zweiten Art, die auf Strahlung in einem zweiten Spektralbereich (S1) empfindlich sind, und Sensorelementen einer dritten Art, die auf Strahlung in einem dritten Spektralbereich (S3) empfindlich sind, wobei die drei Arten von Sensorelementen in sich wiederholendem Muster über die Fläche des Farbbildsensors verteilt sind,
    **dadurch gekennzeichnet,**
    **dass** der erste Spektralbereich (S1) nur eine erste und eine zweite Grundfarbe, der zweite Spektralbereich (S2) nur die zweite und eine dritte Grundfarbe und der dritte Spektralbereich (S3) zumindest die erste und die dritte Grundfarbe umfasst.

2.  Farbbildsensor nach Anspruch 1,
    **dadurch gekennzeichnet,**
    **dass** der dritte Spektralbereich (S3) nur die erste und die dritte Grundfarbe umfasst.

3.  Farbbildsensor nach Anspruch 1,
    **dadurch gekennzeichnet,**
    **dass** der dritte Spektralbereich (S3) die erste, die zweite und die dritte Grundfarbe umfasst.

4.  Farbbildsensor nach einem der vorstehenden Ansprüche,
    **dadurch gekennzeichnet,**
    **dass** die Sensorelemente durch lichtempfindliche Elemente gebildet sind, welche eine spektrale Empfindlichkeit für alle drei Grundfarben aufweisen, wobei die lichtempfindlichen Elemente der Sensorelemente der ersten Art mit einem jeweiligen Filter bedeckt sind, welches lediglich innerhalb des ersten Spektralbereichs (S1) durchlässig ist, und wobei die lichtempfindlichen Elemente der Sensorelemente der zweiten Art mit einem jeweiligen Filter bedeckt sind, welches lediglich innerhalb des zweiten Spektralbereichs (S2) durchlässig ist.

**5.** Farbbildsensor nach Anspruch 4,
**dadurch gekennzeichnet,**
**dass** die lichtempfindlichen Elemente der Sensorelemente der dritten Art mit einem jeweiligen Filter bedeckt sind, welches lediglich innerhalb des dritten Spektralbereichs (S3) durchlässig ist.

**6.** Farbbildsensor nach Anspruch 3 und Anspruch 4,
**dadurch gekennzeichnet,**
**dass** die lichtempfindlichen Elemente der Sensorelemente der dritten Art nicht mit einem Filter bedeckt sind.

**7.** Farbbildsensor nach einem der vorstehenden Ansprüche,
**dadurch gekennzeichnet,**
**dass** die Sensorelemente mit einer Auswerteeinrichtung verbunden sind, welche dazu eingerichtet ist, aus Signalen, die von benachbarten Sensorelementen der ersten, zweiten und dritten Art erzeugt wurden, für jede Grundfarbe eine jeweilige Signalkomponente zu ermitteln.

**8.** Farbbildsensor nach Anspruch 7,
**dadurch gekennzeichnet,**
**dass** die Auswerteeinrichtung dazu eingerichtet ist, die Signalkomponenten auf der Grundlage von algebraischen Operationen, bevorzugt durch Additions- und Subtraktionsoperationen, besonders bevorzugt unter Berücksichtigung von jeweiligen Gewichtungs- oder Skalierungsfaktoren und/oder Gewichtungs- oder Skalierungsfunktionen, zu ermitteln.

**9.** Farbbildsensor nach einem der vorstehenden Ansprüche,
**dadurch gekennzeichnet,**
**dass** die Anzahl der Sensorelemente der dritten Art größer ist als die Anzahl der Sensorelemente der ersten Art oder die Anzahl der Sensorelemente der zweiten Art, bevorzugt doppelt so groß.

Fig. 1
Stand der Technik

Fig. 2

Fig. 3

**Europäisches Patentamt**
**European Patent Office**
**Office européen des brevets**

# EUROPÄISCHER RECHERCHENBERICHT

Nummer der Anmeldung

EP 19 15 2093

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 247 562 A1 (SONY CORP [JP]) 2. Dezember 1987 (1987-12-02) * Spalte 1 - Spalte 4, Zeile 28; Abbildungen 2A,2B *  ----- | 1-9 | INV. G01J3/51 H01L31/0216 H01L27/146 H04N9/04 |

RECHERCHIERTE SACHGEBIETE (IPC)

H01L
G01J
H04N

Der vorliegende Recherchenbericht wurde für alle Patentansprüche erstellt

| Recherchenort | Abschlußdatum der Recherche | Prüfer |
|---|---|---|
| München | 3. Juli 2019 | Haan, Martine |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

............................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 15 2093

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-07-2019

| Im Recherchenbericht angeführtes Patentdokument | Datum der Veröffentlichung | Mitglied(er) der Patentfamilie | Datum der Veröffentlichung |
|---|---|---|---|
| EP 0247562 A1 | 02-12-1987 | DE 3769697 D1<br>EP 0247562 A1<br>JP S62277880 A<br>US 4775885 A | 06-06-1991<br>02-12-1987<br>02-12-1987<br>04-10-1988 |

Für nähere Einzelheiten zu diesem Anhang : siehe Amtsblatt des Europäischen Patentamts, Nr.12/82

EPO FORM P0461